(19) Europäisches Patentamt
European Patent Office
Office européen des brevets

(11) **EP 4 741 985 A1**

(12) **EUROPEAN PATENT APPLICATION**

(43) Date of publication:
**13.05.2026 Bulletin 2026/20**

(21) Application number: **25214194.0**

(22) Date of filing: **07.11.2025**

(51) International Patent Classification (IPC):
**G05F 3/24** (2006.01)   **G05F 3/26** (2006.01)

(52) Cooperative Patent Classification (CPC):
**G05F 3/262; G05F 3/24**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **12.11.2024 US 202463719167 P**

(71) Applicant: eMemory Technology Inc.
**Hsin-Chu**
**300091 (TW)**

(72) Inventors:
• **CHANG, Che-Wei**
**302 Zhubei City, Hsinchu County (TW)**
• **KU, Wei-Ming**
**302 Zhubei City, Hsinchu County (TW)**

(74) Representative: **Krauns, Christian**
**Wallinger Ricker Schlotter Tostmann**
**Patent- und Rechtsanwälte Partnerschaft mbB**
**Zweibrückenstraße 5-7**
**80331 München (DE)**

(54) **REFERENCE CURRENT GENERATOR FOR NON-VOLATILE MEMORY**

(57)    A reference current generator includes two transistors, a resistor and a mirroring circuit. The first transistor includes a source receiving a supply voltage, a drain connected with a first node, and a gate connected with a second node. The second transistor includes a source receiving the supply voltage, and a drain and a gate connected with a third node. The resistor is connected between the second node and the third node. The mirroring circuit includes an input terminal receiving an input current, a first mirrored terminal connected with the second node and a second mirrored terminal connected with the first node. The first mirrored terminal and the second mirrored terminal generate a first mirroring current and a second mirroring current respectively. The first transistor generates a saturation current. A reference current is equal to the saturation current minus the second mirroring current.

FIG. 2

## Description

FIELD OF THE INVENTION

The present invention relates to a current generator, and more particularly to a reference current generator for a non-volatile memory.

BACKGROUND OF THE INVENTION

As is well known, a non-volatile memory includes a memory cell array. The memory cell array is composed of a plurality of non-volatile memory cells. Each non-volatile memory cell includes a storage unit. For example, the storage unit is a floating gate transistor. The storage state of the non-volatile memory cell is determined according to the number of carriers stored in the floating gate of the floating gate transistor.

For example, the floating gate transistor is a P-type floating gate transistor, and the carriers are electrons. When a program action is performed on the memory cell, electrons are controlled to be injected into the floating gate of the floating gate transistor. Meanwhile, carriers are stored in the floating gate, and the memory cell is in a programmed state or an on state. When an erase action is performed on the memory cell, electrons are controlled to be ejected from the floating gate of the floating gate transistor. Meanwhile, carriers are not stored in the floating gate, and the memory cell is in an erased state or an off state. The on state and the off state represent two different storage states of the memory cell.

Alternatively, the floating gate transistor is an N-type floating gate transistor. By controlling the number of carriers stored in the floating gate of the floating gate transistor, the memory cell is selectively in the on state or the off state.

Furthermore, when a read action is performed on the memory cell, the memory cell in the on state generates a larger cell current (also referred to as an on current), and the memory cell in the off state generates a smaller cell current (also referred to as an off current). That is, when the read action is performed, the storage state of the memory cell can be determined according to the magnitude of the cell current generated by the memory cell.

In order to determine the storage state of the memory cell, the non-volatile memory is equipped with a reference current generator and a sensing circuit. The reference current generator generates a reference current. The magnitude of the reference current is set to be in the range between the on current and the off current. When the read action is performed, the sensing circuit receives the reference current and the cell current generated by the memory cell and determines the storage state of the memory cell.

If the cell current is higher than the reference current, the sensing circuit determines that the memory cell is in the programmed state or the on state. If the cell current is lower than the reference current, the sensing circuit determines that the memory cell is in the erased state or the off state.

Generally, after the non-volatile memory is manufactured and tested, it can be determined which process corner the non-volatile memory belongs to. Furthermore, different process corners of the memory cells and different operating temperatures will affect the magnitude of the cell current.

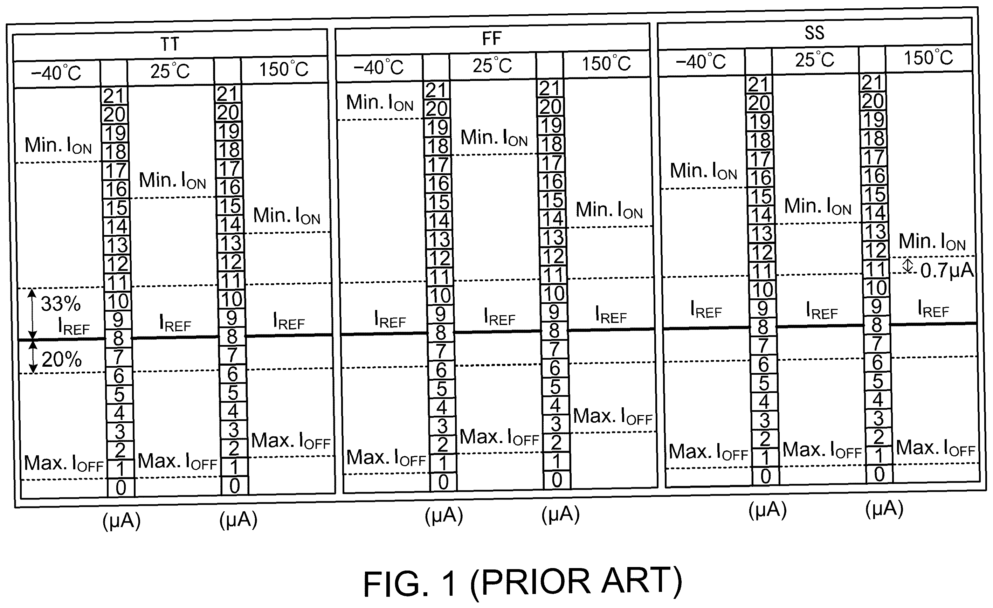

FIG. 1 schematically illustrates the relationships between the cell current and the reference current at various process corners and various operating temperatures for the conventional non-volatile memory.

After all memory cells at a typical-typical corner (also referred to as a TT corner) are read and subjected to a statistics analysis, the following data are obtained. At the operating temperature of -40°C, the minimum on current (Min. $I_{ON}$) of the memory cells in the on state is about 18 $\mu$A, and the maximum off current (Max. $I_{OFF}$) of the memory cell in the off state is about 1 $\mu$A. At the operating temperature of 25°C, the minimum on current of the memory cells in the on state is about 16 $\mu$A, and the maximum off current of the memory cell in the off state is about 1 $\mu$A. At the operating temperature of 150°C, the minimum on current of the memory cells in the on state is about 14 $\mu$A, and the maximum off current of the memory cell in the off state is about 2 $\mu$A.

After all memory cells at a fast-fast corner (also referred to as an FF corner) are read and subjected to a statistics analysis, the following data are obtained. At the operating temperature of -40°C, the minimum on current of the memory cells in the on state is about 20 $\mu$A, and the maximum off current of the memory cell in the off state is about 1 $\mu$A. At the operating temperature of 25°C, the minimum on current of the memory cells in the on state is about 18 $\mu$A, and the maximum off current of the memory cell in the off state is about 2 $\mu$A. At the operating temperature of 150°C, the minimum on current of the memory cells in the on state is about 14 $\mu$A, and the maximum off current of the memory cell in the off state is about 3 $\mu$A.

After all memory cells at a slow-slow corner (also referred to as an SS corner) are read and subjected to a statistics analysis, the following data are obtained. At the operating temperature of -40°C, the minimum on current of the memory cells in the on state is about 16 $\mu$A, and the maximum off current of the memory cell in the off state is about 1 $\mu$A. At the operating temperature of 25°C, the minimum on current of the memory cells in the on state is about 14 $\mu$A, and the maximum off current of the memory cell in the off state is about 1 $\mu$A. At the operating temperature of 150°C, the minimum on current of the memory cells in the on state is about 12 $\mu$A, and the maximum off current of the memory cell in the off state is about 1 $\mu$A.

Please refer to FIG. 1 again. In order to correctly judge the storage states of the memory cells at various process corners and different operating temperatures when the read action is performed, the non-volatile memory is equipped with a reference current generator, and the reference current $I_{REF}$ is set as 8.5μA. Consequently, when the read action is performed, the reference current generator generates a reference current $I_{REF}$ of 8.5μA to the sensing circuit. According to the magnitude of the reference current $I_{REF}$ and the magnitude of the cell current generated by the memory cell, the sensing circuit determines the storage state of the memory cell. That is, if the cell current is higher than the reference current, the sensing circuit determines that the memory cell is in the on state. If the cell current is lower than the reference current, the sensing circuit determines that the memory cell is in the off state.

The reference current generator includes a bandgap reference circuit and a resistor $R_{POLY}$. The resistor $R_{POLY}$ is a polysilicon resistor. The bandgap reference circuit can generate a bandgap voltage $V_{BG}$ that is almost not changed with temperature. For example, the bandgap voltage $V_{BG}$ is 1.2V. The resistance of the polysilicon resistor $R_{POLY}$ is 141.2KΩ. Consequently, the reference current generator can output a reference current $I_{REF}$ of approximately 8.5μA (i.e., $I_{REF}=V_{BG}/R_{POLY}$).

However, the existing semiconductor process is unable to produce polysilicon resistors $R_{POLY}$ with precise resistance values. The error range of the resistance value of polysilicon resistors $R_{POLY}$ produced by the existing semiconductor process is approximately ±25%. After the polysilicon resistor $R_{POLY}$ is completed, its resistance value will be in the range between 105.9KΩ and 176.5KΩ, and the reference current $I_{REF}$ will be in the range between 6.8μA and 11.3μA. In other words, the error range of the reference current $I_{REF}$ is approximately in the range between +33% and -20%.

Please refer to FIG. 1 again. When the memory cell of the SS corner is read at the operating temperature of 150°C, in the worst situation, the reference current $I_{REF}$ generated by the reference current generator is 11.3μA, and the cell current generated by the memory cell is 12μA. Obviously, the difference between the two currents is only about 0.7μA.

Since the difference between the two currents is very small, the sensing circuit will take a long time to judge the storage state. In other words, the reading speed of the non-volatile memory is low. Furthermore, the small difference between the two currents may result in misjudgment of the sensing circuit.

SUMMARY OF THE INVENTION

An embodiment of the present invention provides a reference current generator for a non-volatile memory. The reference current generator includes a first transistor, a second transistor, a first resistor and a first mirroring circuit. A source terminal of the first transistor receives a first supply voltage. A drain terminal of the first transistor is connected with a first node. A gate terminal of the first transistor is connected with a second node. A source terminal of the second transistor receives the first supply voltage. A drain terminal of the second transistor is connected with a third node. A gate terminal of the second transistor is connected with the third node. A first terminal of the first resistor is connected with the third node. A second terminal of the first resistor is connected with the second node. An input terminal of the first mirroring circuit receives an input current. A first mirrored terminal of the first mirroring circuit is connected with the second node. A second mirrored terminal of the first mirroring circuit is connected with the first node. The first mirrored terminal of the first mirroring circuit generates a first mirroring current. The second mirrored terminal of the first mirroring circuit generates a second mirroring current. In addition, there is a first proportional relationship between the input current, the first mirroring current and the second mirroring current. The first transistor and the second transistor are operated in a saturation mode. The first transistor generates a saturation current. The reference current generator outputs a first reference current. The first reference current is equal to the saturation current minus the second mirroring current.

Numerous objects, features and advantages of the present invention will be readily apparent upon a reading of the following detailed description of embodiments of the present invention when taken in conjunction with the accompanying drawings. However, the drawings employed herein are for the purpose of descriptions and should not be regarded as limiting.

BRIEF DESCRIPTION OF THE DRAWINGS

The above objects and advantages of the present invention will become more readily apparent to those ordinarily skilled in the art after reviewing the following detailed description and accompanying drawings, in which:

FIG. 1 (prior art) schematically illustrates the relationships between the cell current and the reference current at various process corners and various operating temperatures for the conventional non-volatile memory;

FIG. 2 is a schematic circuit diagram illustrating the circuitry structure of a reference current generator according to an embodiment of the present invention;

FIGS. 3A and 3B are schematic circuit diagrams illustrating various exemplary input current generators for generating the input current to the reference current generator of the present invention;

FIGS. 4A and 4B are schematic circuit diagrams illustrating some examples of an additional mirroring circuit of the reference current generator;

FIG. 5 is a schematic circuit diagram illustrating a sensing circuit for the non-volatile memory of the present invention; and

FIG. 6 schematically illustrates the relationships between the cell current and the reference current at various process corners and various operating temperatures for the non-volatile memory of the present invention.

DETAILED DESCRIPTION OF PREFERRED EMBODIMENTS

The present invention provides a reference current generator for a non-volatile memory. The reference current generator and the non-volatile memory are constructed on the same IC chip. That is, the transistors of the reference current generator and the memory cells of the non-volatile memory are produced at the same process corner. Consequently, the reference current from the reference current generator is related to the process corner of the memory cell. Furthermore, the reference current from the reference current generator varies with the change of operating temperature.

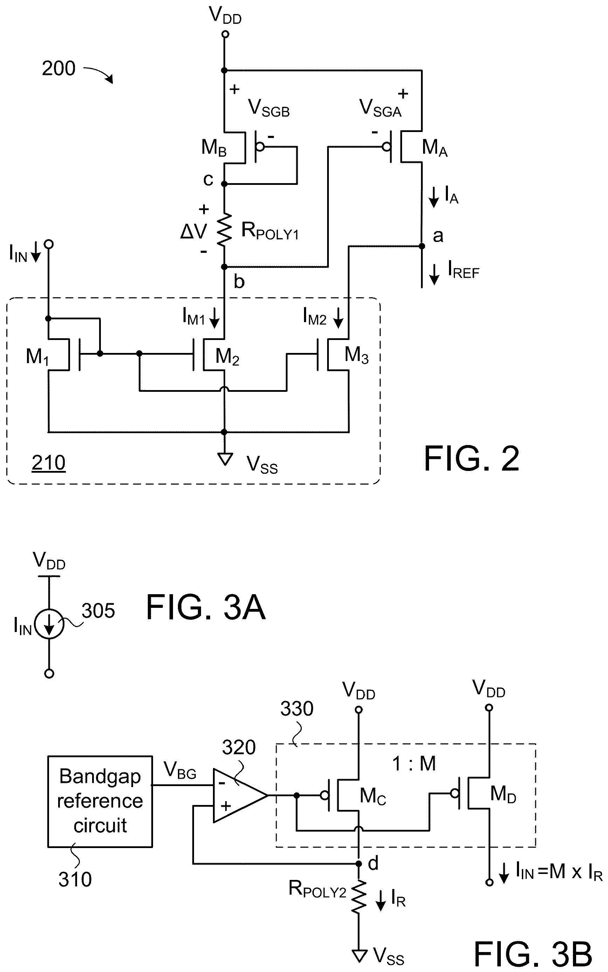

FIG. 2 is a schematic circuit diagram illustrating the circuitry structure of a reference current generator according to an embodiment of the present invention. As shown in FIG. 2, the reference current generator includes a mirroring circuit 210, two transistors $M_A$, $M_B$ and a resistor $R_{POLY1}$.

The source terminal of the transistor $M_A$ receives a supply voltage $V_{DD}$. The drain terminal of the transistor $M_A$ is connected with the node a. The gate terminal of the transistor $M_A$ is connected with the node b. The source terminal of the transistor $M_B$ receives the supply voltage $V_{DD}$. The drain terminal of the transistor $M_B$ is connected with the node c. The gate terminal of the transistor $M_B$ is connected with the node c. The first terminal of the resistor $R_{POLY1}$ is connected with the node c. The second terminal of the resistor $R_{POLY1}$ is connected with the node b. In addition, the resistor $R_{POLY1}$ is a polysilicon resistor.

The mirroring circuit 210 includes an input terminal, a first mirrored terminal and a second mirrored terminal. The input terminal of the mirroring circuit 210 receives an input current $I_{IN}$. The first mirrored terminal of the mirroring circuit 210 is connected with the node b. The first mirrored terminal can generate a first mirroring current $I_{M1}$. The second mirrored terminal of the mirroring circuit 210 is connected with the node a. The second mirrored terminal can generate a second mirroring current $I_{M2}$. Furthermore, there is a specified proportional relationship between the input current $I_{IN}$, the first mirroring current $I_{M1}$ and the second mirroring current $I_{M2}$.

In an embodiment, the mirroring circuit 210 includes three transistors $M_1$, $M_2$, and $M_3$. The drain terminal of the transistor $M_1$ is served as the input terminal to receive the input current $I_{IN}$. The source terminal of the transistor $M_1$ receives the supply voltage $V_{SS}$. The gate terminal of the transistor $M_1$ is connected with the drain terminal of the transistor $M_1$. The drain terminal of the transistor $M_2$ is served as the first mirrored terminal. The drain terminal of the transistor $M_2$ is connected with the node b. The source terminal of the transistor $M_2$ receives the supply voltage $V_{SS}$. The gate terminal of the transistor $M_2$ is connected with the gate terminal of the transistor $M_1$. The drain terminal of the transistor $M_3$ is served as the second mirrored terminal. The drain terminal of the transistor $M_3$ is connected with the node a. The source terminal of the transistor $M_3$ receives the supply voltage $V_{SS}$. The gate terminal of the transistor $M_3$ is connected with the gate terminal of the transistor $M_1$. The proportional relationship between the input current $I_{IN}$, the first mirroring current $I_{M1}$ and the second mirroring current $I_{M2}$ can be determined according to the sizes of the transistors $M_1$, $M_2$ and $M_3$. Furthermore, the supply voltage $V_{DD}$ is higher than supply voltage $V_{SS}$. For example, the supply voltage $V_{DD}$ is 3.3V, and the supply voltage Vss is 0V.

In an embodiment, the ratio of the input current $I_{IN}$, the first mirroring current $I_{M1}$ and the second mirroring current $I_{M2}$ in the mirroring circuit 210 is 1:2:2. When the reference current generator 200 is operated normally, the transistors $M_A$ and $M_B$ are operated in a saturation mode. Meanwhile, the transistor $M_A$ generates a saturation current $I_A$, and the reference current generator 200 outputs a reference current $I_{REF}$. The reference current $I_{REF}$ is equal to the saturation current $I_A$ minus the second mirroring current $I_{M2}$. That is, $I_{REF} = I_A - I_{M2}$.

As mentioned above, $I_{M1}:I_{M2}=2\times I_{IN}$, $I_{M1}:I_{M2}=K_P\times(V_{ODB})^2$, and $I_A=K_P\times(V_{ODA})^2$, wherein $K_P$ is a device parameter of p-type transistor. For example, the transistor $M_A$ and the transistor $M_B$ have the same size, the same device parameter $K_P$ and the same threshold voltage $V_T$, and $V_T$ is negative. Furthermore, $V_{ODA}$ is the over-drive voltage of the transistor $M_A$, and $V_{ODB}$ is the over-drive voltage of the transistor $M_B$, wherein $V_{ODA}=(V_{SGA}+V_T)$, $V_{ODB}=(V_{SGB}+V_T)$, $V_{SGA}$ is the source-gate voltage of the transistor $M_A$, and $V_{SGB}$ is the source-gate voltage of the transistor $M_B$.

According to the results of FIG. 2, it can be found that $V_{SGA}=V_{SGB}+\Delta V$, wherein $\Delta V$ is the voltage drop across the resistor $R_{POLY1}$. Consequently, $I_{REF} = I_A - I_{M1} = K_P\times(V_{ODA}^2-V_{ODB}^2) = K_P\times(V_{ODA}+V_{ODB})\times(V_{ODA}-V_{ODB})$, considering $V_{ODB}$ is replaced by $(V_{ODA}-\Delta V)$, $I_{REF} = K_P\times(2V_{ODA}-\Delta V)\times\Delta V$.

If $2V_{ODA}$ is much higher than $\Delta V$, $(2V_{ODA}-\Delta V)$ is approximately equal to $2V_{ODA}$. Consequently, considering $I_A=K_P\times(V_{ODA})^2$, where $V_{ODA}$ is replaced by $I_A$ and $K_P$, it can be deduced that

$$I_{REF} = 2\times K_P\times V_{ODA}\times\Delta V = 2\times\sqrt{I_A\times K_P}\times\Delta V$$

. For example, if $V_{ODA}$ is at least five times higher than $\Delta V$, it can be regarded that $2V_{ODA}$ is much higher than $\Delta V$.

In an embodiment, the device parameter of p-type transistor may be expressed as: $K_P = (1/2) \times \mu_P \times C_{OX} \times (W/L)$, wherein $\mu_P$ is the hole mobility, Cox is the oxide capacitance, W is the channel width, and L is the channel length. Generally, the device parameter $K_P$ of p-type transistor at the FF corner is the largest, the device parameter $K_P$ of p-type transistor at the FF corner at the TT corner is the second largest, and the device parameter $K_P$ of p-type transistor at the FF corner at the SS corner is the smallest. In other words, $K_P(FF) > K_P(TT) > K_P(SS)$. As mentioned above, the transistors in the memory cells and the transistors $M_A$ and $M_B$ belong to the same process corner. According to the above formula about the reference current $I_{REF}$ under the same bias condition, the reference current $I_{REF}$ for the P-type transistors $M_A$ and $M_B$ at the FF corner is higher, and the reference current $I_{REF}$ for the P-type transistors $M_A$ and $M_B$ at the SS corner is lower.

Generally, the hole mobility $\mu_P$ decreases with the increasing temperature. For example, the hole mobility $\mu_P$ is the lowest at the operating temperature of 150°C, the hole mobility $\mu_P$ is the second lowest at the operating temperature of 25°C, and the hole mobility $\mu_P$ is the highest at the operating temperature of -40°C. In other words, $\mu_P(150°C) < \mu_P(25°C) < \mu_P(-40°C)$. According to the above formula about the reference current $I_{REF}$ under the same bias condition, the reference current $I_{REF}$ at the operating temperature of 150°C is lower, and the reference current $I_{REF}$ at the operating temperature of -40°C is higher.

FIGS. 3A and 3B are schematic circuit diagrams illustrating various exemplary input current generators for generating the input current to the reference current generator of the present invention.

As shown in FIG. 3A, the input current generator includes a current source 305. The current source 305 generates the input current $I_{IN}$. The input current $I_{IN}$ is inputted into the input terminal of the mirroring circuit 210.

As shown in FIG. 3B, the input current generator includes a bandgap reference circuit 310, an operational amplifier 320, a mirroring circuit 330 and a resistor $R_{POLY2}$. The bandgap reference circuit 310 generates a bandgap voltage $V_{BG}$. For example, the resistor $R_{POLY2}$ is a polysilicon resistor connected with the node d. An input terminal of the mirroring circuit 330 is connected to the node d to receive a first current $I_R$, and a mirrored terminal of the mirroring circuit 330 is capable of generating the input current $I_{IN}$. The operational amplifier 320 receives the bandgap voltage $V_{BG}$, and the operational amplifier 320 is connected to the node d and the mirroring circuit 330 to control the mirroring circuit 330.

The mirroring circuit 330 includes two transistors Mc and $M_D$. The source terminals of the transistor Mc and $M_D$ receive the supply voltage $V_{DD}$, the gate terminals of the transistor $M_C$ and $M_D$ are connected with each other and further connected to the output terminal of the operational amplifier 320, the drain terminal of the transistor Mc is served as the input terminal of the mirroring circuit 330, and the drain terminal of the transistor $M_D$ is served as the mirrored terminal of the mirroring circuit 330. An inverting input terminal of the operational amplifier 320 receives the bandgap voltage $V_{BG}$, a non-inverting terminal of the operational amplifier 320 is connected to the node d, an output terminal is connected to the gate terminal of the transistor Mc. Moreover, a first terminal of the resistor $R_{POLY2}$ is connected with the node d, and a second terminal of the resistor $R_{POLY2}$ receives the supply voltage $V_{SS}$.

In an embodiment, the ratio of the first current $I_R$ and the input current $I_N$ in the mirroring circuit 330 is 1:M, and M is a positive real number. When the input current generator is operated normally, the voltage at the node d is equal to the bandgap voltage $V_{BG}$, the first current $I_R$ is equal to $V_{SG}/R_{POLY2}$, the input current $I_{IN}$ is equal to $M \times I_R$, and the input current $I_{IN}$ is inputted into the input terminal of the mirroring circuit 210. That is, there is a proportional relationship between the first current $I_R$ and the input current $I_{IN}$. For example, when M is equal to 1, the input current $I_{IN}$ is equal to the first current $I_R$, and the input current $I_{IN}$ is equal to $V_{BG}/R_{POLY2}$.

In the input current generator of FIG. 3B, the resistor $R_{POLY2}$ is a polysilicon resistor. That is, when the reference current generator 200 is manufactured on an IC chip, the resistor $R_{POLY1}$ and the resistor $R_{POLY2}$ will have the same error, and thus the voltage drop $\Delta V$ across the resistor $R_{POLY1}$ can be maintained at a fixed value and will be nearly unchanged.

Generally, the non-volatile memory further includes a sensing circuit. When a read action is performed, the sensing circuit receives the reference current $I_{REF}$ from the reference current generator 200 and determines the storage state of the memory cell according to the reference current $I_{REF}$.

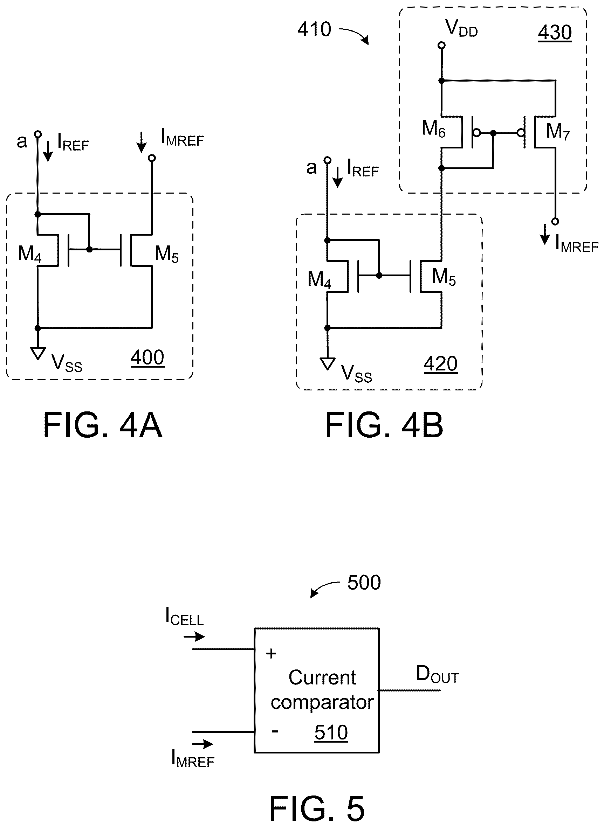

In a variant example, the reference current generator 200 further includes an additional mirroring circuit to generate a mirrored reference current $I_{MREF}$. When a read action is performed, the sensing circuit receives the mirrored reference current $I_{MREF}$ from the reference current generator 200 and determines the storage state of the memory cell according to the mirrored reference current $I_{MREF}$. FIGS. 4A and 4B are schematic circuit diagrams illustrating some examples of an additional mirroring circuit of the reference current generator.

As shown in FIG. 4A, the input terminal of the mirroring circuit 400 is connected with the node a to receive the reference current $I_{REF}$, and the mirrored terminal of the mirroring circuit 400 generates the mirrored reference current $I_{MREF}$. Furthermore, there is a specified proportional relationship between the reference current $I_{REF}$ and the mirrored reference current $I_{MREF}$.

In an embodiment, the mirroring circuit 400 includes two transistors $M_4$ and $M_5$. The drain terminal of the transistor $M_4$ is connected with the node a to receives the reference current $I_{REF}$. The source terminal of the transistor $M_4$ receives the supply voltage Vss. The gate terminal of the transistor $M_4$ is connected with the drain terminal of the transistor $M_4$. The drain terminal of the transistor $M_5$ is served as the mirrored terminal to receive the mirrored reference current $I_{MREF}$. The source terminal of the transistor $M_5$ receives the supply voltage $V_{SS}$. The gate terminal of the transistor $M_5$ is connected with the gate terminal of the transistor $M_4$.

As shown in FIG. 4B, the mirroring circuit 410 includes two current mirrors 420 and 430. The input terminal of the mirroring circuit 410 is connected with the node a to receive the reference current $I_{REF}$, and the mirrored terminal of the mirroring circuit 410 generates the mirrored reference current $I_{MREF}$. Furthermore, there is a specified proportional relationship between the reference current $I_{REF}$ and the mirrored reference current $I_{MREF}$.

In an embodiment, the current mirror 420 includes two transistors $M_4$ and $M_5$, and the current mirror 430 includes two transistors $M_6$ and $M_7$. The drain terminal of the transistor $M_4$ is connected with the node a to receives the reference current $I_{REF}$. The source terminal of the transistor $M_4$ receives the supply voltage $V_{SS}$. The gate terminal of the transistor $M_4$ is connected with the drain terminal of the transistor $M_4$. The source terminal of the transistor $M_5$ receives the supply voltage $V_{SS}$. The gate terminal of the transistor $M_5$ is connected with the gate terminal of the transistor $M_4$. The drain terminal of the transistor $M_6$ is connected with the drain terminal of the transistor $M_5$. The source terminal of the transistor $M_6$ receives the supply voltage $V_{DD}$. The gate terminal of the transistor $M_6$ is connected with the drain terminal of the transistor $M_6$. The drain terminal of the transistor $M_7$ generates the mirrored reference current $I_{MREF}$. The source terminal of the transistor $M_7$ receives the supply voltage $V_{DD}$. The gate terminal of the transistor $M_7$ is connected with the gate terminal of the transistor $M_6$.

FIG. 5 is a schematic circuit diagram illustrating a sensing circuit for the non-volatile memory of the present invention.

In an embodiment, the sensing circuit 500 receives the mirrored reference current $I_{MREF}$ and receives the cell current $I_{CELL}$ from the memory cell, and the sensing circuit 500 determines the storage state of the memory cell according to the mirrored reference current $I_{MREF}$ and the cell current $I_{CELL}$. Alternatively, in another embodiment, the sensing circuit 500 receives the reference current $I_{REF}$ and the cell current $I_{CELL}$, and the sensing circuit 500 determines the storage state of the memory cell according to the reference current $I_{REF}$ and the cell current $I_{CELL}$.

For example, the sensing circuit 500 includes a current comparator 510. A first input terminal (e.g., a positive input terminal) of the current comparator 510 receives the cell current $I_{CELL}$. A second input terminal (e.g., a negative input terminal) of the current comparator 510 receives the mirrored reference current $I_{MREF}$. An output terminal of the current comparator 510 generates an output signal $D_{OUT}$.

If the cell current $I_{CELL}$ is higher than the mirrored reference current $I_{MREF}$, the current comparator 510 generates an output signal $D_{OUT}$ of a first logic level (e.g., a logic high level), indicating that the memory cell is in a programmed state or an on state. If the cell current $I_{CELL}$ is lower than the mirrored reference current $I_{MREF}$, the current comparator 510 generates an output signal $D_{OUT}$ of a second logic level (e.g., a logic low level), indicating that the memory cell is in an erased state or an off state. In an embodiment, when the storage state of the memory cell is determined according to the reference current $I_{REF}$ instead of the mirrored reference current $I_{MREF}$, two current mirrors 420 and 430 can be omitted, and the second input terminal of the current comparator 510 receives the reference current $I_{REF}$.

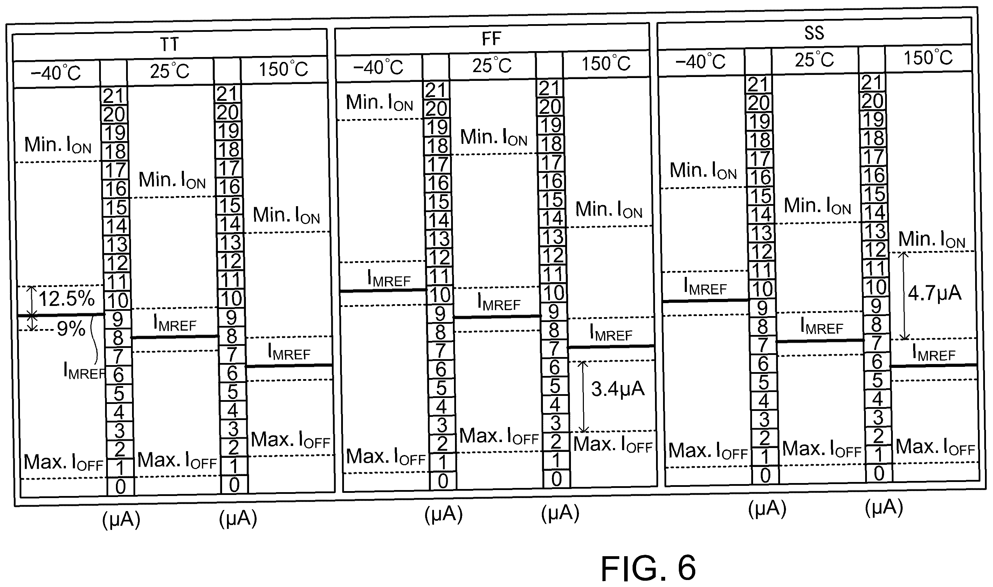

FIG. 6 schematically illustrates the relationships between the cell current and the reference current at various process corners and various operating temperatures for the non-volatile memory of the present invention.

As previously described, the reference current generator in the conventional non-volatile memory provides a fixed reference current. In contrast, the reference current $I_{REF}$ or the mirrored reference current $I_{MREF}$ provided by the reference current generator of the present invention varies with the process corner and the operating temperature.

For example, the reference current generator 200 is designed according to the transistors at the TT corner. In addition, the reference current generator 200 generates the mirrored reference current $I_{MREF}$ of 8.5μA at the operating temperature of 25°C.

Please refer to FIG. 6. In case that the memory cells and the reference current generator have the transistors at the TT corner, the following data are obtained. After the non-volatile memory is manufactured, the reference current generator 200 at the operating temperature of 25°C will generate the mirrored reference current $I_{MREF}$ of 8.5μA. Generally, the hole mobility $\mu_P$ decreases with the increasing temperature. In other words, $\mu_P$(150°C) < $\mu_P$(25°C) < $\mu_P$(-40°C). At the operating temperature of 150°C, the mirrored reference current $I_{MREF}$ decreases to approximately 6.9μA. At the operating temperature of -40°C, the mirrored reference current $I_{MREF}$ increases to approximately 9.6μA.

Please refer to FIG. 6. In case that the memory cells and the reference current generator have the transistors at the FF corner, the following data are obtained. After the non-volatile memory is manufactured, the mirrored reference current $I_{MREF}$ generated by the reference current generator 200 at the operating temperature of 25°C increases to approximately 9.3μA because the device parameter $K_P$(FF) is greater than the device parameter $K_P$(TT). Generally, the hole mobility $\mu_P$ decreases with the increasing temperature. In other words, $\mu_P$(150°C) < $\mu_P$(25°C) < $\mu_P$(-40°C). At the operating temperature of 150°C, the mirrored reference current $I_{MREF}$ decreases to approximately 7.7μA. At the operating temperature of -40°C, the mirrored reference current

$I_{MREF}$ increases to approximately 10.8μA.

Please refer to FIG. 6. In case that the memory cells and the reference current generator have the transistors at the SS corner, the following data are obtained. After the non-volatile memory is manufactured, the mirrored reference current $I_{MREF}$ generated by the reference current generator 200 at the operating temperature of 25°C decreases to approximately 7.8μA because the device parameter $K_P(TT)$ is greater than the device parameter $K_P(SS)$. Generally, the hole mobility $\mu_P$ decreases with the increasing temperature. In other words, $\mu_P$ (150°C) < $\mu_P$(25°C) < $\mu_P$(-40°C). At the operating temperature of 150°C, the mirrored reference current $I_{MREF}$ decreases to approximately 6.2μA. At the operating temperature of -40°C, the mirrored reference current $I_{MREF}$ increases to approximately 9.9μA.

Furthermore, the change of the reference current $I_{REF}$ is in direct proportion to the square root of the change of the saturation current $I_A$, i.e.,

$$\Delta I_{REF} \propto \sqrt{\Delta I_A}$$

, and there is a specified proportional relationship between the reference current $I_{REF}$ and the mirrored reference current $I_{MREF}$. Since the saturation current $I_A$ varies with process and temperature conditions, using its square root to define $I_{REF}$ helps reduce the impact of the process and temperature conditions. Consequently, the reference current $I_{REF}$ is less sensitive to the process variations and temperature changes, and the error of the mirrored reference current $I_{MREF}$ is also smaller in comparison with the error of the saturation current $I_A$.

As shown in FIG. 6, the error range of the mirrored reference current $I_{MREF}$ is approximately between +12.5% and -9%. Consequently, when the memory cell at the SS corner is subjected to the read action at the operating temperature of 150°C, the current difference between the mirrored reference current $I_{MREF}$ and the cell current from the memory cell in the worst situation is approximately 4.7μA. In other words, if this current difference is sufficiently large, the sensing circuit 500 can determine the storage state of the memory cell correctly.

Furthermore, when the memory cell at the FF corner is subjected to the read action at the operating temperature of 150°C, the current difference between the mirrored reference current $I_{MREF}$ and the cell current from the memory cell in the worst situation is approximately 3.4μA. In other words, if this current difference is sufficiently large, the sensing circuit 500 can determine the storage state of the memory cell correctly.

From the above descriptions, the present invention provides a reference current generator for a non-volatile memory. The transistors of the reference current generator and the memory cells of the non-volatile memory are produced at the same process corner. Consequently, the reference current from the reference current generator is related to the process corner of the memory cell. Furthermore, the reference current from the reference current generator varies with the change of operating temperature.

While the invention has been described in terms of what is presently considered to be the most practical and preferred embodiments, it is to be understood that the invention needs not be limited to the disclosed embodiment. On the contrary, it is intended to cover various modifications and similar arrangements included within the spirit and scope of the appended claims which are to be accorded with the broadest interpretation so as to encompass all such modifications and similar structures.

**Claims**

1. A reference current generator (200) for a non-volatile memory, the reference current generator (200) comprising:

a first transistor ($M_A$), wherein a source terminal of the first transistor ($M_A$) receives a first supply voltage ($V_{DD}$), a drain terminal of the first transistor is connected with a first node (a), and a gate terminal of the first transistor is connected with a second node (b);
a second transistor ($M_B$), wherein a source terminal of the second transistor ($M_B$) receives the first supply voltage ($V_{DD}$), a drain terminal of the second transistor ($M_B$) is connected with a third node (c), and a gate terminal of the second transistor is connected with the third node (c);
a first resistor ($R_{POLY1}$), wherein a first terminal of the first resistor ($R_{POLY1}$) is connected with the third node (c), and a second terminal of the first resistor ($R_{POLY1}$) is connected with the second node (b); and
a first mirroring circuit (210), wherein an input terminal of the first mirroring circuit (210) receives an input current ($I_{IN}$), a first mirrored terminal of the first mirroring circuit (210) is connected with the second node (b), and a second mirrored terminal of the first mirroring circuit (210) is connected with the first node (a), wherein the first mirrored terminal of the first mirroring circuit (210) generates a first mirroring current ($I_{M1}$), the second mirrored terminal of the first mirroring circuit (210) generates a second mirroring current ($I_{M2}$), and there is a first proportional relationship between the input current ($I_{IN}$), the first mirroring current ($I_{M1}$) and the second mirroring current ($I_{M2}$);
wherein the first transistor ($M_A$) and the second transistor ($M_B$) are operated in a saturation mode, and the first transistor ($M_A$) generates a saturation current ($I_A$),
wherein the reference current generator (100) outputs a first reference current ($I_{REF}$), and the first reference current ($I_{REF}$) is equal to the saturation current ($I_A$) minus the second mirroring current ($I_{M2}$).

2. The reference current generator as claimed in claim 1, wherein an over-drive voltage of the first transistor is at least five times a voltage drop across the first resistor, and the over-drive voltage of the first transistor is equal to a source-gate voltage of the first transistor plus a threshold voltage of the first transistor.

3. The reference current generator as claimed in claim 1 or 2, wherein the first mirroring circuit comprises:

    a third transistor, wherein a drain terminal of the third transistor receives the input current, a gate terminal of the third transistor is connected with the drain terminal of the third transistor, and a source terminal of the third transistor receives a second supply voltage;
    a fourth transistor, wherein a drain terminal of the fourth transistor is connected with the second node, a gate terminal of the fourth transistor is connected with the gate terminal of the third transistor, and a source terminal of the fourth transistor receives the second supply voltage; and
    a fifth transistor, wherein a drain terminal of the fifth transistor is connected with the first node, a gate terminal of the fifth transistor is connected with the gate terminal of the third transistor, and a source terminal of the fifth transistor receives the second supply voltage,
    wherein the first supply voltage is higher than the second supply voltage.

4. The reference current generator as claimed in anyone of the claims 1 to 3, further comprising a current source, wherein the current source generates the input current, and the input current is inputted into the input terminal of the mirroring circuit.

5. The reference current generator as claimed in claim 1, further comprising:

    a bandgap reference circuit generating a bandgap voltage;
    a second resistor, wherein a first terminal of the second resistor is connected with a fourth node and a second terminal of the receives a second supply voltage;
    a second mirroring circuit, wherein an input terminal of the second mirroring circuit is connected with the fourth node to receive a first current, and a mirrored terminal of the second mirroring circuit generates the input current; and
    an operational amplifier, wherein an inverting input terminal of the operational amplifier receives the bandgap voltage, a non-inverting input terminal of the operational amplifier is connected with the fourth node, and an output terminal is connected with the second mirroring circuit to control the second mirroring circuit.

6. The reference current generator as claimed in claim 5, wherein the first current is equal to the bandgap voltage divided by a resistance of the second resistor, and there is a second proportional relationship between the first current and the input current.

7. The reference current generator as claimed in claim 5 or 6, wherein the first resistor and the second resistor are polysilicon resistors.

8. The reference current generator as claimed in anyone of the claims 5 to 7, wherein the second mirroring circuit comprises:

    a third transistor, wherein a source terminal of the third transistor receives the first supply voltage, a gate terminal of the third transistor is connected with the output terminal of the operational amplifier, and a drain terminal of the third transistor is connected with the fourth node; and
    a fourth transistor, wherein a source terminal of the fourth transistor receives the first supply voltage, a gate terminal of the fourth transistor is connected with the output terminal of the operational amplifier, and a drain terminal of the fourth generates the input current;
    wherein the first supply voltage is higher than the second supply voltage.

9. The reference current generator as claimed in claim 1, further comprising a second mirroring circuit, wherein an input terminal of the second mirroring circuit is connected with the first node to receive the first reference current, and a mirrored terminal of the second mirroring circuit generates a second reference current, wherein there is a second proportional relationship between the first reference current and the second reference current.

10. The reference current generator as claimed in claim 9, wherein the second mirroring circuit comprises:

    a third transistor, wherein a drain terminal of the third transistor is connected with the first node to receive the first reference current, a gate terminal of the third transistor is connected with the drain terminal of the third transistor, and a source terminal of the third transistor receives a second supply voltage; and
    a fourth transistor, wherein a drain terminal of the fourth transistor is served as the mirrored terminal of the second mirroring circuit to generate the second reference current, a gate terminal of the fourth transistor is connected with the gate terminal of the third transistor, and a source terminal of the fourth transistor receives the second supply voltage,

wherein the first supply voltage is higher than the second supply voltage.

11. The reference current generator as claimed in claim 9 or 10, wherein the second mirroring circuit comprises:

a third transistor, wherein a drain terminal of the third transistor is connected with the first node to receive the first reference current, a gate terminal of the third transistor is connected with the drain terminal of the third transistor, and a source terminal of the third transistor receives a second supply voltage;

a fourth transistor, wherein a gate terminal of the fourth transistor is connected with the gate terminal of the third transistor, and a source terminal of the fourth transistor receives the second supply voltage;

a fifth transistor, wherein a drain terminal of the fifth transistor is connected with a drain terminal of the fourth transistor, a gate terminal of the fifth transistor is connected with the drain terminal of the fifth transistor, and a source terminal of the fifth transistor receives the second supply voltage; and

a sixth transistor, wherein a drain terminal of the sixth transistor is served as the mirrored terminal of the second mirroring circuit to generate the second reference current, a gate terminal of the sixth transistor is connected with the gate terminal of the fifth transistor, and a source terminal of the sixth transistor receives the second supply voltage,

wherein the first supply voltage is higher than the second supply voltage.

12. The reference current generator as claimed in anyone of the claims 9 to 11, wherein the non-volatile memory comprises a memory cell and a sensing circuit, wherein when a read action is performed, the sensing circuit receives a cell current from the memory cell and the second reference current from the reference current generator, and the sensing circuit determines a storage state of the memory cell according to the cell current and the second reference current.

13. The reference current generator as claimed in claim 12, wherein if the cell current is higher than the second reference current, the sensing circuit determines that the memory cell is in a programmed state, wherein if the cell current is lower than the second reference current, the sensing circuit determines that the memory cell is in an erased state.

FIG. 1 (PRIOR ART)

EP 4 741 985 A1

FIG. 2

FIG. 3A

FIG. 3B

FIG. 4A

FIG. 4B

FIG. 5

FIG. 6

EP 4 741 985 A1

## EUROPEAN SEARCH REPORT

Europäisches Patentamt
European Patent Office
Office européen des brevets

**Application Number**

EP 25 21 4194

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 10 503 197 B2 (ABLIC INC [JP]) 10 December 2019 (2019-12-10) * abstract; figure 1 * | 1-13 | INV. G05F3/24 G05F3/26 |
| A | US 2014/240050 A1 (SHIMIZU KAN [JP]) 28 August 2014 (2014-08-28) * abstract; figure 1 * | 1-13 | |
| A | US 8 542 060 B2 (TOMIOKA TSUTOMU [JP]; SUGIURA MASAKAZU [JP]; SEIKO INSTR INC [JP]) 24 September 2013 (2013-09-24) * abstract; figure 1 * | 1-13 | |
| A | HU JINLONG ET AL: "A novel precision CMOS current reference for IoT systems", AEU - INTERNATIONAL JOURNAL OF ELECTRONICS AND COMMUNICATIONS, ELSEVIER, AMSTERDAM, NL, vol. 130, 5 January 2021 (2021-01-05), XP086466092, ISSN: 1434-8411, DOI: 10.1016/J.AEUE.2020.153577 [retrieved on 2021-01-05] * abstract; figure 9 * | 1-13 | **TECHNICAL FIELDS SEARCHED (IPC)** G05F |
| A | US 9 000 749 B2 (SEIKO INSTR INC [JP]) 7 April 2015 (2015-04-07) * abstract; figure 2 * | 1-13 | |

The present search report has been drawn up for all claims

| Place of search | Date of completion of the search | Examiner |
|---|---|---|
| The Hague | 7 March 2026 | Arias Pérez, Jagoba |

EPO FORM 1503 03.82 (P04C01)

## ANNEX TO THE EUROPEAN SEARCH REPORT
## ON EUROPEAN PATENT APPLICATION NO.

EP 25 21 4194

This annex lists the patent family members relating to the patent documents cited in the above-mentioned European search report.
The members are as contained in the European Patent Office EDP file on
The European Patent Office is in no way liable for these particulars which are merely given for the purpose of information.

07-03-2026

| Patent document cited in search report | | Publication date | Patent family member(s) | | Publication date |
|---|---|---|---|---|---|
| US 10503197 | B2 | 10-12-2019 | CN | 109960309 A | 02-07-2019 |
| | | | JP | 6956619 B2 | 02-11-2021 |
| | | | JP | 2019106094 A | 27-06-2019 |
| | | | KR | 20190071590 A | 24-06-2019 |
| | | | TW | 201931045 A | 01-08-2019 |
| | | | US | 2019187739 A1 | 20-06-2019 |
| US 2014240050 | A1 | 28-08-2014 | JP | 5801333 B2 | 28-10-2015 |
| | | | JP | 2014167731 A | 11-09-2014 |
| | | | US | 2014240050 A1 | 28-08-2014 |
| US 8542060 | B2 | 24-09-2013 | CN | 102402237 A | 04-04-2012 |
| | | | JP | 5706653 B2 | 22-04-2015 |
| | | | JP | 2012063848 A | 29-03-2012 |
| | | | KR | 20120028233 A | 22-03-2012 |
| | | | TW | 201224698 A | 16-06-2012 |
| | | | US | 2012062312 A1 | 15-03-2012 |
| US 9000749 | B2 | 07-04-2015 | CN | 103092239 A | 08-05-2013 |
| | | | JP | 2013097551 A | 20-05-2013 |
| | | | KR | 20130047658 A | 08-05-2013 |
| | | | TW | 201337501 A | 16-09-2013 |
| | | | US | 2013106394 A1 | 02-05-2013 |

EPO FORM P0459

For more details about this annex : see Official Journal of the European Patent Office, No. 12/82